(19) Europäisches Patentamt
European Patent Office
Office européen des brevets

(11) **EP 4 365 612 A1**

(12) **EUROPEAN PATENT APPLICATION**
published in accordance with Art. 153(4) EPC

(43) Date of publication:
**08.05.2024 Bulletin 2024/19**

(21) Application number: 22831729.3

(22) Date of filing: **17.06.2022**

(51) International Patent Classification (IPC):
**G01R 31/388** (2019.01)    **G01R 31/36** (2020.01)
**G01R 31/382** (2019.01)    **G01R 31/367** (2019.01)
**G06F 30/20** (2020.01)    **H01M 10/44** (2006.01)
**B60L 58/10** (2019.01)    **H02J 7/00** (2006.01)

(52) Cooperative Patent Classification (CPC):
Y02T 10/70

(86) International application number:
**PCT/CN2022/099327**

(87) International publication number:
**WO 2023/273911 (05.01.2023 Gazette 2023/01)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **28.06.2021 CN 202110718358**

(71) Applicants:
• **Zhejiang Geely Holding Group Co., Ltd.
Hangzhou, Zhejiang 310051 (CN)**
• **Zhejiang Liankong Technologies Co., Ltd
Ningbo, Zhejiang 315336 (CN)**

(72) Inventors:
• **DENG, Zhongqing
Hangzhou Bay New District Ningbo, Zhejiang
315336 (CN)**
• **HU, Zhengnan
Hangzhou Bay New District Ningbo, Zhejiang
315336 (CN)**
• **GUAN, Bicong
Hangzhou Bay New District Ningbo, Zhejiang
315336 (CN)**
• **XU, Haihua
Hangzhou Bay New District Ningbo, Zhejiang
315336 (CN)**

• **NIU, Wei
Hangzhou Bay New District Ningbo, Zhejiang
315336 (CN)**
• **LI, Jintao
Hangzhou Bay New District Ningbo, Zhejiang
315336 (CN)**
• **JU, Jingchen
Hangzhou Bay New District Ningbo, Zhejiang
315336 (CN)**
• **ZHAO, Weihong
Hangzhou Bay New District Ningbo, Zhejiang
315336 (CN)**
• **TIAN, Hao
Hangzhou Bay New District Ningbo, Zhejiang
315336 (CN)**
• **WU, Xuejian
Hangzhou Bay New District Ningbo, Zhejiang
315336 (CN)**
• **NIU, Yaqi
Hangzhou Bay New District Ningbo, Zhejiang
315336 (CN)**

(74) Representative: **Zaboliene, Reda
Metida
Business center Vertas
Gyneju str. 16
01109 Vilnius (LT)**

(54) **REMAINING BATTERY CHARGING TIME ESTIMATION METHOD AND APPARATUS**

(57)     Disclosed are a remaining battery charging time estimation method and apparatus. The method comprises: determining charge intervals (S102); estimating non end-of-charge charging times; estimating an end-of-charge time according to multiple stored historical end-of-charge times (S106); summing an early-charge time, a mid-charge time, a late-charge time, and the end-of-charge time to obtain a theoretical remaining charging time and displaying timing (S108); during a charging process, repeatedly performing the described steps S102-S108 at intervals of a preset time period, and correcting a displayed remaining charging time displayed

**(Cont. next page)**

EP 4 365 612 A1

in a current period according to the theoretical remaining charging time determined in the current period (S110); and when a current battery charge amount reaches a starting end of end-of-charge, using the end-of charge time as the displayed remaining charging time, and displaying a countdown until the battery charge amount reaches a target charge amount (S112). Accuracy of the estimated remaining charging time is improved by correcting a displayed battery initial remaining charging time by means of determining a battery theoretical remaining charging time in real time.

determining a plurality of charging intervals from current battery charge amount to target charge amount according to the target charge amount, the current battery charge amount, and a MAP table, the MAP table including a plurality of preset and continuous charge amount intervals, each charge amount interval including two charge amount nodes, and the charge interval including: early charging period, middle charging period, late charging period and final charging period — 102

according to the current battery charge amount, the target charge amount, and each charge amount node in the MAP table, respectively estimating the early charging period time from the current battery charge amount to the end value of the early charging period, the middle charging period time from the end value of the early charging period to the end value of the middle charging period, and the late charging period time from the end value of the middle charging period to the end value of the late charging period — 104

estimating the final charging period time according to multiple stored historical final charging period times — 106

accumulating the early charging period time, the middle charging period time, the late charging period time and the final charging period time to obtain a theoretical remaining charging time, and using the theoretical remaining charging time as the displayed remaining charging time and countdown displaying the displayed remaining charging time — 108

during the charging process, repeatedly executing S102-S108 at preset time intervals, and correcting the displayed remaining charging time displayed in the current cycle according to the theoretical remaining charging time determined in the current cycle until the current battery charge amount reaches the begin value of the final charging period — 110

when the current battery charge amount reaches the begin value of the final charging period, using the final charging period time as the displayed remaining charging time and countdown displaying the displayed remaining charging time until the battery charge reaches the target charge amount — 112

FIG.1

**Description**

**TECHNICAL FIELD**

The present application relates to the field of battery technology, in particular to a remaining battery charging time estimation method and apparatus.

**BACKGROUND TECHNIQUE**

During the charging process of electric vehicles, the accurate remaining charging time of the battery can enhance the user's comfort; the inaccurate remaining charging time will make the user experience discount;

to estimate the remaining charging time of the battery in the battery management system, the remaining charging time is generally calculated by dividing the remaining charging capacity by the charging current. Since the charging current will change, the displayed value will change drastically, rising and falling from time to time, and the visual perception is poor;

the battery management system estimates the remaining charging time of the battery, divides the entire charging process into several stages based on the cell voltage, and obtains the dynamic charging request current $I(n,t)$ by combining the charging capacity $Q$ of each stage and the temperature at different stages to estimate the remaining charging time. The charging time $T=Q/I(n,t)$ of each stage is the estimated remaining charging time after accumulation.

In fact, at the end of charging, the time from the highest battery voltage of the single cell to the charging cut-off voltage to 100% full charge is relatively long, and the time calculated by $T=Q/I(n,t)$ is usually too small, resulting in a large error in the estimation value of the remaining charging time at the charging end, which affects the experience.

**SUMMARY OF THE INVENTION**

The present application provides a remaining battery charging time estimation method, the method including:

S102. determining a plurality of charging intervals from current battery charge amount to target charge amount according to the target charge amount, the current battery charge amount, and a MAP table, the MAP table including a plurality of preset and continuous charge amount intervals, each charge amount interval including two charge amount nodes, and the charge interval including: early charging period, middle charging period, late charging period and final charging period;

S104. according to the current battery charge amount, the target charge amount, and each charge amount node in the MAP table, respectively estimating the early charging period time from the current battery charge amount to the end value of the early charging period, the middle charging period time from the end value of the early charging period to the end value of the middle charging period, and the late charging period time from the end value of the middle charging period to the end value of the late charging period;

S106. estimating the final charging period time according to multiple stored historical final charging period times;

S108. accumulating the early charging period time, the middle charging period time, the late charging period time and the final charging period time to obtain a theoretical remaining charging time, and using the theoretical remaining charging time as the displayed remaining charging time and countdown displaying the displayed remaining charging time;

S110. during the charging process, repeatedly executing S102-S108 at preset time intervals, and correcting the displayed remaining charging time displayed in the current cycle according to the theoretical remaining charging time determined in the current cycle until the current battery charge amount reaches the begin value of the final charging period;

S112. when the current battery charge amount reaches the begin value of the final charging period, using the final charging period time as the displayed remaining charging time and countdown displaying the displayed remaining charging time until the battery charge reaches the target charge amount.

Further, estimating the final charging period time according to the multiple stored historical final charging period times includes:

using the average value of the multiple stored historical final charging period times as the final charging period time, wherein the historical final charging period time is the actual charging time from the begin value of the final charging period time to the target charge amount in the historical final charging period time.

Further, the begin value of the final charging period time is determined by the service life of the battery combined with the initial test data of the battery and the usage data of the battery using a specific SOC setting method or a specific potential setting method.

Further, determining a plurality of charging intervals from current battery charge amount to target charge amount according to the target charge amount, the current battery charge amount, and the MAP table, includes:
when the difference between the current battery charge amount and the end value of the late charging period is a plurality of the charge amount intervals, using the interval in which a termination node is located as the early charging period, wherein the termination node is a charge amount node which has the lowest difference with the current battery charge in the MAP table, and using the termination node to the starting node in the MAP table interval where the end value of the late charging period is located as the middle charging period, acting the starting node in the MAP table interval where the end value of the late charging period is located to the end value of the late charging period as the late charging period, and acting the end value of the late charging period to the target charge amount as the final charging period.

Further, according to the current battery charge amount, the target charge amount, and each charge amount node in the MAP table, respectively estimating the early charging period time from the current battery charge amount to the end value of the early charging period, the middle charging period time from the end value of the early charging period to the end value of the middle charging period, and the late charging period time from the end value of the middle charging period to the end value of the late charging period, includes:

obtaining the charging current in the MAP table corresponding to each charging stage, and calculating the average charging current in the current charging stage according to the charging current collected in the current charging stage of the battery;

calculating the remaining charging time of the battery in the current charging stage according to the terminal value of the battery in the current charging stage, the current charge amount of the battery, and the average charging current in the current charging stage;

based on the terminal value of each charging stage after the current charging stage and the charging current in each subsequent charging stage, calculating the remaining charging time of the battery in each charging stage after the current charging stage and before the final charging period.

Further, correcting the displayed remaining charging time displayed in the current cycle according to the theoretical remaining charging time determined in the current cycle by the following formula:

$$T_{dispk+1} = T_{dispk} - \eta * ( T_{dispk} / T_{theok}) * T_{step}$$

Among them, $T_{dispk+1}$ is the displayed remaining charging time of the k+1th sampling time, $T_{dispk}$ is the displayed remaining charging time of the kth sampling time, $\eta$ is the correction factor, and $T_{theok}$ is the theoretical remaining charging determined at the kth sampling time, $T_{step}$ preset time period.

In another aspect, the present invention provides a remaining battery charging time estimation apparatus, the apparatus including:

a charging interval determination module, configured to perform determining a plurality of charging intervals from current battery charge amount to target charge amount according to the target charge amount, the current battery charge amount, and a MAP table, the MAP table including a plurality of preset and continuous charge amount intervals, each charge amount interval including two charge amount nodes, and the charge interval including: early charging period, middle charging period, late charging period and final charging period;

a non-final charging period time determination module, configured to perform according to the current battery charge amount, the target charge amount, and each charge amount node in the MAP table, respectively estimating the early charging period time from the current battery charge amount to the end value of the early charging period, the middle charging period time from the end value of the early charging period to the end value of the middle charging period, and the late charging period time from the end value of the middle charging period to the end value of the late charging period;

a final charging period time determination module, configured to estimate the final charging period time based on a plurality of stored historical final charging period times;

the first theoretical charging time determination module, configured to perform accumulating the early charging period time, the middle charging period time, the late charging period time and the final charging period time to obtain a theoretical remaining charging time, and using the theoretical remaining charging time as the displayed remaining charging time and countdown display the displayed remaining charging time;

the repeated execution module, configured to perform during the charging process, returning to the charging interval determination module, the non-final charging period time determination module, the final charging period time determination module, and the first theoretical charging time determination module at preset time intervals during the charging process, and correcting the displayed remaining charging time displayed in the current cycle according to the theoretical remaining charging time determined in the current cycle until the current battery charge amount reaches the begin value of the final charging period;

the second theoretical charging time determination module, configured to perform when the current battery charge amount reaches the begin value of the final charging period, using the final charging period time as the displayed remaining charging time and countdown displaying the displayed remaining charging time until the battery charge reaches the target charge amount.

Further, the final charging period time determination module includes: a final charging period time determining unit, configured to perform the calculation of the average value of a plurality of stored historical final charging period times as the final charging period time, wherein the historical final charging period time is the actual charging time from the begin value of the final charging period time to the target charge amount in the historical final charging period time.

In another aspect, the present invention provides a computer-readable storage medium, at least one instruction or at least one program is stored in the computer-readable storage medium, and the at least one instruction or at least one program is loaded and executed by a processor to realize The remaining battery charging time estimation method is as described above.

In another aspect, the present invention provides an electronic apparatus, including at least one processor, and a memory connected in communication with the at least one processor; wherein, the memory stores instructions executable by the at least one processor, the at least one processor implements the remaining battery charging time estimation method as described above by executing the instructions stored in the memory.

The theoretical remaining charging time determined in real time is used to correct the displayed remaining charging time, and the charging end is set up. The charging process from the charging end as the starting point to the target charge is independently estimated. The actual charging time in multiple historical charging cycles is used to estimate the charging time at the end of the charge, so as to improve the accuracy of the estimated remaining charging time

## DESCRIPTION OF DRAWINGS

In order to more clearly explain the technical scheme in the embodiments of the present application or the prior art, the following is a brief introduction of the drawings required to be used in the description of the embodiments or the prior art. Obviously, the drawings described below are only some embodiments of the present application. Other drawings can also be obtained from these drawings.

FIG. 1 is a flowchart of a remaining battery charging time estimation method provided in an embodiment of the present application;
FIG. 2 is a division diagram of the charging stages provided by the embodiment of this specification;
FIG. 3 is a schematic structural diagram of a remaining battery charging time estimation apparatus provided in an embodiment of the present application;

Among them, 710-charging interval determination module, 720-non-final charging period time determination module, 730-final charging period time determination module, 740-first theoretical charging time determination module, 750-repeated execution module, 760-second theoretical charging time determination module.

## EMBODIMENTS OF THE PRESENT APPLICATION

In order to make the purpose, technical solution and advantages of the application clearer, the application will be further described in detail below in conjunction with the accompanying drawings. Apparently, the described embodiments are only some of the embodiments of the present application, rather than all the embodiments. Based on the embodiments in the present application, all other embodiments obtained by persons of ordinary skill in the art without making creative efforts belong to the protection scope of the present application.

In the description of the present application, it should be understood that the terms first and second are only used for descriptive purposes, and cannot be interpreted as indicating or implying relative importance or implicitly indicating the quantity of indicated technical features. Thus, a feature defined as first or second may explicitly or implicitly includes one or more of these features. Also, the terms first, second, etc. are used to distinguish similar objects and are not necessarily used to describe a specific order or sequence. It is to be understood that the data so used are interchangeable under appropriate circumstances such that the embodiments of the application described herein can be practiced in sequences other than those illustrated or described herein.

In the embodiment of the present invention, the remaining charging time in the charging process of the battery is estimated. From the type of the battery, the battery can be a lithium ion battery, a lithium metal battery, a lead-acid battery, a nickel battery, a nickel hydrogen battery, Lithium-sulfur batteries, lithium-air batteries, or sodium-ion batteries are not specifically limited in this embodiment of the present invention. In terms of battery scale, the battery in the embodiment of the present invention may be a single battery cell, or a battery module or battery pack, which is not specifically limited in the embodiment of the present invention.

In the embodiment of the present invention, the battery charging process may include n charging stages, the charging current of each charging stage is {I1, I2, ..., In}, and the charging cut-off voltage corresponding to the charging current of each charging stage {V1 , V2,..., Vn}.

As an example, the charging process of the battery in the embodiment of the present invention is:

charge the battery with the charging current I1, and when the charging voltage of the battery reaches V1, enter the next charge interval;
charge the battery with the charging current I2, when the charging voltage of the battery reaches V2, enter the next charging interval; ...; In the last charging interval, charge the battery with the charging current In, when the charging voltage of the battery reaches Vn, stop charging.

As another example, the charging process of the battery in the embodiment of the present invention is:

charge the battery with the charging current I0, and when the charging voltage of the battery reaches V0, enter the next charge interval;
charge the battery with the charging current I1, when the battery charging voltage reaches V1, enter the next charge interval; charge the battery with the charging current I2, when the battery charging voltage reaches V2, enter the next charge interval;...; in the last charge interval, the battery is charged with the charging current In until it is fully charged.

In the embodiment of the invention, when charging the power battery, the whole charging process is divided into different charge intervals according to the charging cutoff voltage within the whole temperature interval. When the current charge interval enters the next charge interval, the charging current of the current charge interval will be switched to the charging current of the next charge interval to charge the battery. The output current of the charging device is not very stable, and the fluctuation of the output current will cause the remaining time of charging to jump.

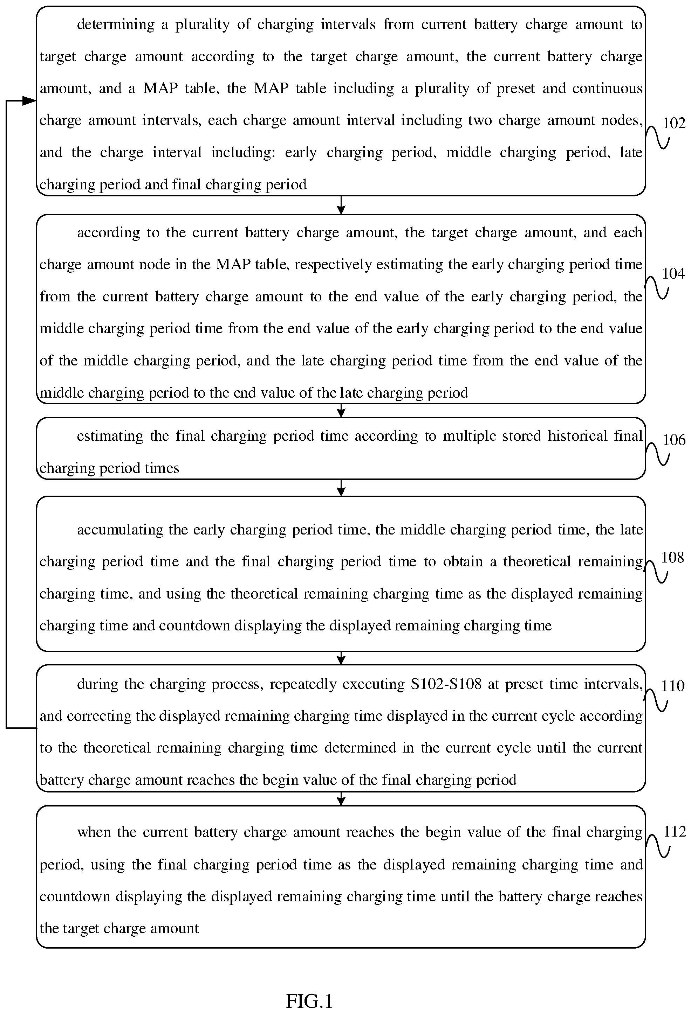

In order to better understand the present invention, the remaining battery charging time estimation method according to the embodiment of the present invention will be described in detail below in conjunction with the accompanying drawings, please refer to FIG.1, which is a flowchart of a remaining battery charging time estimation method provided by the embodiment of the present application that may be applied during battery charging;
the methods include:

S102. determining a plurality of charging intervals from current battery charge amount to target charge amount according to the target charge amount, the current battery charge amount, and a MAP table, the MAP table comprising a plurality of preset and continuous charge amount intervals, each charge amount interval including two charge amount nodes, and the charge interval including: early charging period, middle charging period, late charging period and final charging period.

In a specific implementation process, the begin value of the final charging period time is determined by using a specific SOC setting method or a specific potential setting method according to the service life of the battery combined with the initial test data of the battery and the usage data of the battery. Due to the difference in the service life of the battery, the charging time at the end of charging is also different. The starting point of the final charging period can be inversely proportional to the service life of the battery, that is, the longer the service life of the battery, the smaller the starting point of the final charging period.

It can be understood that the early charging period, the middle charging period, the late charging period and the final charging period may respectively correspond to charge quantity intervals corresponding to multiple MAP tables. The charging interval and the charge interval use different dimensions to divide the battery charge interval, and each node in the charge interval can be determined by the MAP table.

S104. according to the current battery charge amount, the target charge amount, and each charge amount node in the MAP table, respectively estimating the early charging period time from the current battery charge amount to the end value of the early charging period, the middle charging period time from the end value of the early charging period to the end value of the middle charging period, and the late charging period time from the end value of the middle charging period to the end value of the late charging period.

Specifically, the method for estimating the early charging period time, middle charging period time, and final charging period time can be:

(1) estimating the early charging period time

The charging time required from 4% of the current charge to the 5% of the right node of the current charge amount interval 1 can be:

$$T_{early} = (5\%\text{-}4\%)*C_{rated}/I_{req1};$$

Among them, Crated is the rated capacity, 50AH, and $I_{req1}$ is the requested current of charging stage 1, which is obtained according to the MAP table.

(2) estimating the middle charging period time

The charging time required from the 5% of the right node of the current charge amount interval 1 to the 97% of the left node of the charging target charge amount interval 12 can be:

$$T_{middle} = \Delta \text{ charge amount } _2*C_{rated}/I_{req2}+\Delta \text{ charge amount } _3*C_{rated}/T_{req3}+...+\Delta \text{ charge amount } _{11}*C_{rated}/I_{req11};$$

wherein, the difference $\Delta$ charge amount 2, 3... 11 of the charge amount in the middle charging period is determined according to the charge amount interval of the battery MAP table.

(3) estimating the late charging period time

The charging time required from the 97% of the left node of the charging capacity interval 12 to the end value of the late charging period end of the charging target charging capacity interval can be:

$$T_{late}= \Delta \text{ charge amount (terminal value of late charging period - 97\%) } * C_{rated}/I_{req12}.$$

S106. estimating the final charging period time according to multiple stored historical final charging period times.
Specifically, estimating the final charging period time according to multiple stored historical final charging period times includes:
using the average value of the multiple stored historical final charging period times as the final charging period time, wherein the historical final charging period time is the actual charging time from the begin value of the final charging period time to the target charge amount in the historical final charging period.
Specifically, $T_{final}$ is the charging time from the begin value of the final charging period to the target charging amount according to the multiple stored historical charging cycles.
For example, the charging time of the three times of the historical final charging period respectively is t1=25min, t2=29min, and t3=30min respectively, and the charging time of the current final charging period can be determined to be 28min by means of an average.
S108. accumulating the early charging period time, the middle charging period time, the late charging period time, and the final charging period time to obtain a theoretical remaining charging time, and using the theoretical remaining charging time as the displayed remaining charging time to display and count down displaying the displayed remaining charging time.
S110. during the charging process, repeatedly execute S102-S108 at preset time intervals, and correcting the displayed remaining charging time displayed in the current cycle according to the theoretical remaining charging time determined in the current cycle until the current battery charge amount reaches the begin value of the final charging period.
Specifically, data such as the current charge amount and the target charge amount can be reacquired at intervals of a preset time period, and the corresponding charging stage can be re-determined. It is understandable that the various begin values and terminal values in the charging stage can change with time.
S112. when the current battery charge amount reaches the begin value of the final charging period, using the final charging period time as the displayed remaining charging time and countdown displaying the displayed remaining charging time until the battery charge reaches the target charge amount.
For example, when the battery is being charged, when the charge of the battery is already at the final charging period, the charge amount of the battery can be 99.5%, and the charging time of the final charging period can be determined according to the actual charging time at the final charging period in multiple historical charging cycles, the remaining battery charging time is determined according to the ratio of the battery charge amount to the battery capacity.

The charging time of the final charging period for the first three times is t1=25min, t2=29min, t3=30min, and the charging time of the final charging period can be determined to be 28min by means of the average. That is, T=28*(100%-99.5%)/(100%-99.3%)=20min. Among them, 99.3% can be the charging amount at the begin point of the final charging period.

After the actual charging ends, record the actual charging time of the final charging period of this time t=32min.

In some possible embodiments, the actual charging time at the end of this charge can be recorded in an iterative manner:

that is, tn in the storage unit is replaced by tn-1, t2 is replaced by t1, and tn+1 is replaced by tn, and the update is:

$$t1=29min, \ t2=30min, \ t3=32min.$$

On the basis of the above embodiments, in one embodiment of this specification, determining a plurality of charging intervals from current battery charge amount to target charge amount according to the target charge amount, the current battery charge amount, and the MAP table, includes:

when the difference between the current battery charge amount and the end value of the late charging period is a plurality of the charge amount intervals, using the interval in which a termination node is located as the early charging period, wherein the termination node is a charge amount node which has the lowest difference with the current battery charge in the MAP table, and using the termination node to the starting node in the MAP table interval where the end value of the late charging period is located as the middle charging period, acting the starting node in the MAP table interval where the end value of the late charging period is located to the end value of the late charging period as the late charging period, and acting the end value of the late charging period to the target charge amount as the final charging period.

Exemplarily, 1) For example, the charging amount at the begin point of the final charging period is 99.3%;

2) The charge amount interval of the battery MAP table can be divided into 12 intervals: [0%, 5%), [5%, 10%), [10%, 20%), [30%, 40%), [40% ,50%), [50%,60%), [60%,70%), [70%,80%), [80%,90%), [90%,95%), [95%,97 %), [97%, 100%].

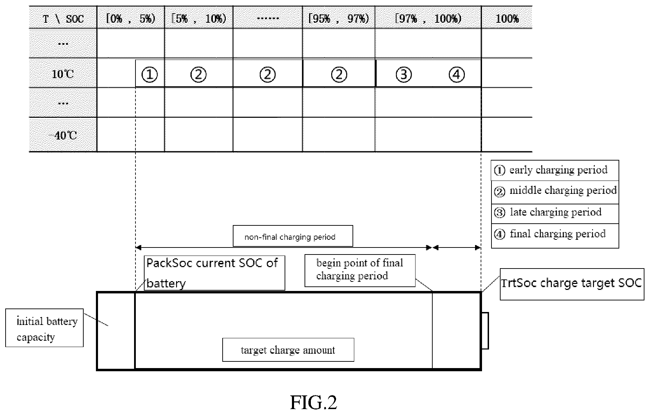

As shown in FIG. 2, FIG. 2 is a division diagram of the charging stages provided by the embodiment of this specification. When the current charge amount of the battery is 4%, [0%, 5%) can be determined as the early charging period, and [5%, 10%), [10%, 20%), [30%, 40%), [40%, 50%), [50%, 60%), [60%, 70%), [70%, 80% ), [80%, 90%), [90%, 95%), [95%, 97%) is the middle charging period, [97%, 99.3%) is the late charging period, [99.7%, 100%] is the final charging period.

At an environment temperature of 10°C, charge the battery from 4% of the battery state of charge amount to 100% of the target charge amount.

When the current charge amount is 5%, the early charging period can be empty, [5%, 10%), [10%, 20%), [30%, 40%), [40%, 50%), [50% %, 60%), [60%, 70%), [70%, 80%), [80%, 90%), [90%, 95%), [95%, 97%) are the middle charging amount, [ 97%, 99.3%) is the late charging period, and [99.7%, 100%] is the final stage of charging.

It can be understood that, when the value of the current charge amount is a node value of the charge amount interval, the early charging period may be a null value.

On the basis of the above embodiments, in one embodiment of this specification, the correction of the displayed remaining charging time displayed in the current cycle based on the theoretical remaining charging time determined in the current cycle is corrected by the following formula:

$$T\_(dispk+1) \ = T\_(dispk )-\eta*( T\_dispk \ / T\_theok) * T\_step$$

Among them, $T_{dispk+1}$ is the displayed remaining charging time of the k+1th sampling time, $T_{dispk}$ is the displayed remaining charging time of the kth sampling time, $\eta$ is the correction factor, and $T_{theok}$ is the theoretical remaining charging determined at the kth sampling time Time, $T_{step}$ is preset time period.

Specifically, when the battery is being charged in the intervals of the early charging period, the middle charging period, and the late charging period, according to the theoretical remaining charging time re-determined by the charging parameters real-time collected from the battery, the displayed remaining charging time of the current cycle is corrected.

For example, at the start of charging, the displayed battery remaining charging time $T_{disp}$ is set to $T_{theo}$, that is, step 0, $T_{disp0}=T_{theo0}$, where $T_{theo}$ is the battery remaining charging time recalculated during the charging process.

With the change of $T_{theo}$ recalculated during the charging process, the remaining charging time of the battery Tdisp will change accordingly, and the processing is as follows:

Before the final charging period, the battery theoretical remaining charging time $T_{theo}$ update method:

As $T_{disp} > T_{theo} + T_{preset\ jump\ time\ threshold\ value}$, then the displayed remaining charge time displayed in the k+1 step is revised based on the displayed remaining charge time of the k step, $T_{dispk+1} = T_{dispk} - \eta*(T_{dispk}/T_{theok})*T_{step}$.

As $T_{disp} < T_{theo} + T_{preset\ jump\ time\ threshold\ value}$, then the display remaining charge time displayed in the k+1 step is revised based on the display remaining charge time of the k step, $T_{dispk+1} = T_{dispk} - \eta*(T_{dispk}/T_{theok})*T_{step}$.

In other cases, $T_{dispn+1}$ remains as $T_{dispn}$.

Wherein, $\eta$ is a correction factor $\eta = [0 \sim 1]$, and $T_{step}$ is a preset time period (sampling period).

At the final charging period, the displayed remaining battery charging time $T_{disp}$ is the recalculated battery remaining charging time $T_{theo}$ during the charging process.

During the whole process, the jump of the initial remaining charging time $T_{disp}$ of the battery is controlled not to exceed $T_{preset\ jump\ time\ threshold\ value}$.

On the basis of the above embodiments, in one embodiment of this specification, according to the current battery charge amount, the target charge amount, and each charge amount node in the MAP table, respectively estimating the early charging period time from the current battery charge amount to the end value of the early charging period, the middle charging period time from the end value of the early charging period to the end value of the middle charging period, and the late charging period time from the end value of the middle charging period to the end value of the late charging period, includes:

obtaining the charging current in the MAP table corresponding to each charging stage, and calculating the average charging current in the current charging stage according to the charging current collected in the current charging stage of the battery.

In some embodiments, the charging current in each charging interval may be affected by the charging environment temperature, or be affected by the charging environment temperature and the state of charge of the battery at the same time. Therefore, a table of correspondences between the charging current and the charging environment temperature in each charging stage may be established in advance, or a table of correspondences between the charging current in each charging interval and the charging environment temperature and the state of charge of the battery may be established in advance.

Based on the corresponding relationship table between the charging current and the charging environment temperature, the charging current of each charging interval is obtained by looking up the table through the current charging environment temperature.

Or, based on the table of correspondence between charging current, charging environment temperature, and battery state of charge, the charging current for each charging interval can be obtained by looking up the table through the current charging environment temperature and battery state of charge.

In this step, in order to ensure the stability of the current, the average value of the charging current in the current charging interval within a predetermined period of time can be used as the average charging current in the current charging interval to prevent the unstable charging current from causing subsequent damage to the remaining time estimation error.

As an example, the average value of the charging current within 30s of the current charge interval of the battery is taken as the average charging current in the current charging stage.

Calculating the remaining charging time of the battery in the current charging stage according to the terminal value of the battery in the current charging stage, the current charge amount of the battery, and the average charging current in the current charging stage;

Specifically, the remaining charging time of the battery in the current charging interval is calculated by using the following formula.

$$Tm = (charge\ target - charge\ disp) \times Capacity \div Im$$

Among them, Tm is the remaining charging time of the battery in the current charge interval, the charge target is the target charge state of the battery in the current charge interval, the charge disp is the current charge state of the battery, and Capacity is the battery's capacity, Im is the average charging current in the current charging interval.

Based on the terminal value of each charging stage after the current charging stage and the charging current in each subsequent charging stage, calculating the remaining charging time of the battery in each charging stage after the current charging stage and before the final charging period.

According to the battery remaining charging time estimation method of the embodiment of the invention, the target charging state at the switching point of the charging stage at the charging cut-off voltage can be calculated in real time, and the remaining charging time of different charging stages can be distributed and calculated, and the total remaining charging time can be obtained by adding the method, so as to solve the jump problem in the calculation process of the remaining charging time.

As an example, estimating the remaining charging time that has not entered the final charging period

At the beginning of charging, 4% which is the current charge is less than 99.3% which is the begin point charge amount of the final charging period, then:

step 0, the remaining charging time of the battery recalculated during the initial charging process (unit: min): $T_{theo0} = T_{early} + T_{middle} + T_{late} + T_{final}$

step 1, $T_{disp1} = T_{theo0}$

......

in the kth step, as the recalculated battery remaining charging time $T_{theo}$ decreases during the charging process, in the kth step, assuming $T_{dispk} < T_{theok} + T_{\text{preset jump time threshold value}}$

In step k+1, if $T_{dispk} > T_{theok} + T_{\text{preset jump time threshold value}}$, then $T_{dispk+1} = T_{dispk} - \eta * (T_{dispk}/T_{theok}) * T_{step}$.

......

among them, the $T_{\text{preset jump time threshold value}}$ is 2min, the $\eta$ correction factor is 1, and the Tstep step size is 0.02s.

(3) Estimating the remaining charging time that has entered the final charging period

As the current charging capacity is greater than or equal to 99.3% which is the begin point charging amount of the final stage, then estimate the theoretical remaining battery charging time:

$$T_{theo} = T_{final} - t = 27\text{-}t$$

Wherein, t is the elapsed real time after entering the final charging period.

The displayed remaining charging time $T_{disp}$ is directly expressed as the remaining charging time $T_{theo}$ of the battery recalculated during the charging process.

(4) Jump processing for the displayed remaining charging time

In the charging process (2) (3), controlling the displayed remaining charging time $T_{disp}$ does not exceed the preset jump time threshold value, and the preset jump time threshold value is 3 minutes.

(5) After the charging is finished, counting the time to update

After the charging is finished, counting the charging time t=32min at the end of this charging, and the current recorded data is:

$$t1=25\text{min},\ t2=29\text{min},\ t3=30\text{min}$$

In turn, replace $t_n$ in the storage unit with $t_{n-1}$, $t_2$ with $t_1$, and $t_{n+1}$ with $t_n$. After the update, it becomes: $t_1$=29min, $t_2$=30min, $t_3$=32min.

The application provides a remaining battery charging time estimation method, which corrects the displayed theoretical remaining charging time through the theoretical remaining charging time determined in real time, and sets up a charging end, and the charging process from the charging end as the begin point to the target charge amount is independent estimate, use the actual charging time in multiple historical charging cycles to estimate the charging time at the final charging period, and improve the accuracy of the estimated remaining charging time.

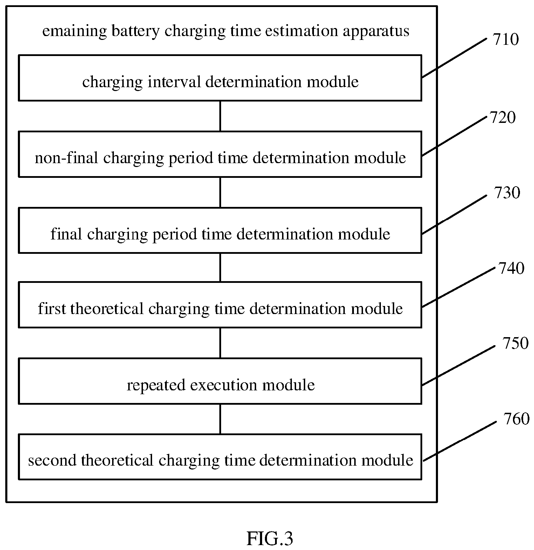

On the other hand, FIG. 3 is a schematic structural diagram of a remaining battery charging time estimation apparatus provided in an embodiment of the present application. As shown in FIG. 3 , the present invention provides a remaining battery charging time estimation apparatus, which is characterized in that the apparatus include:

a charging interval determination module 710, configured to perform determining a plurality of charging intervals from current battery charge amount to target charge amount according to the target charge amount, the current battery charge amount, and a MAP table, the MAP table comprising a plurality of preset and continuous charge amount intervals, each charge amount interval comprising two charge amount nodes, and the charge interval including: early charging period, middle charging period, late charging period and final charging period;

a non-final charging period time determination module 720, configured to perform according to the current battery charge amount, the target charge amount, and each charge amount node in the MAP table, respectively estimating the early charging period time from the current battery charge amount to the end value of the early charging period, the middle charging period time from the end value of the early charging period to the end value of the middle charging period, and the late charging period time from the end value of the middle charging period to the end value of the late charging period;

a final charging period time determination module 730, configured to estimate the final charging period time based on a plurality of stored historical final charging period times;

a first theoretical charging time determination module 740, configured to perform accumulating the early charging period time, the middle charging period time, the late charging period time and the final charging period time to obtain a theoretical remaining charging time, and using the theoretical remaining charging time as the displayed remaining charging time and countdown display the displayed remaining charging time;

a repeated execution module 750, configured to perform during the charging process, returning to the charging interval determination module, the non-final charging period time determination module, the final charging period time determination module, and the first theoretical charging time determination module at preset time intervals during the charging process, and correcting the displayed remaining charging time displayed in the current cycle according to the theoretical remaining charging time determined in the current cycle until the current battery charge amount reaches the begin value of the final charging period;

a second theoretical charging time determination module 760, configured to perform when the current battery charge amount reaches the begin value of the final charging period, using the final charging period time as the displayed remaining charging time and countdown displaying the displayed remaining charging time until the battery charge reaches the target charge amount.

On the basis of the above-mentioned embodiments, in one embodiment of this specification, the final charging period time determination module includes: a final charging period time determination unit configured to use the average value of multiple stored historical final charging period times as the final charging period time, so the historical final charging period time is the actual charging time from the initial end value of the charging end to the target charge amount in the historical charging end.

This embodiment also provides a computer-readable storage medium, in which computer-executable instructions are stored, and the computer-executable instructions are loaded by a processor to execute the above-mentioned remaining battery charging time estimation method in this embodiment.

This embodiment also provides a computer program product or computer program, where the computer program product or computer program includes computer instructions, and the computer instructions are stored in a computer-readable storage medium. The processor of the computer apparatus reads the computer instructions from the computer-readable storage medium, and the processor executes the computer instructions, so that the computer apparatus executes the above remaining battery charging time estimation method.

This embodiment also provides an electronic apparatus, the electronic apparatus includes a processor and a memory, wherein the memory stores a computer program, and the computer program is suitable for being loaded by the processor and executing the estimation of the remaining charging time of the battery described above in this embodiment method.

The apparatus may be a computer terminal, a mobile terminal, or a server, and the apparatus may also participate in constituting the apparatus or system provided by the embodiment of the present application.

Based on this understanding, the technical solution of the present application is essentially or part of the contribution to the prior art or all or part of the technical solution can be embodied in the form of a software product, and the computer software product is stored in a storage medium , including instructions for making a computer apparatus (which may be a personal computer, a server, or a network apparatus, etc.) execute all or part of the steps of the methods in the various embodiments of the present application. The aforementioned storage medium includes: U disk, mobile hard disk, read-only memory (ROM, Read-Only Memory), random access memory (RAM, Random Access Memory), magnetic disk or optical disk and other media that can store program codes..

Those skilled in the art can further realize that the units and algorithm steps of the examples described in conjunction with the embodiments disclosed in this specification can be realized by electronic hardware, computer software or a combination of the two. In order to clearly illustrate the hardware and software Interchangeability. In the above description, the composition and steps of each example have been generally described according to their functions. Whether these functions are executed by hardware or software depends on the specific application and design constraints of the technical solution. Those skilled in the art may use different methods to implement the described functions for each specific application, but such implementation should not be regarded as exceeding the scope of the present application.

The above embodiments are only used to illustrate the technical solutions of the present application, rather than to limit them; although the present application has been described in detail with reference to the foregoing embodiments, those of ordinary skill in the art should understand that: it can still apply to the foregoing embodiments Modifications are made to the recorded technical solutions, or equivalent replacements are made to some of the technical features; and these modifications or replacements do not make the essence of the corresponding technical solutions deviate from the spirit and scope of the technical solutions of the embodiments of the present application.

**Claims**

1. A remaining battery charging time estimation method, **characterized in that** the method comprises:

   S102. determining a plurality of charging intervals from current battery charge amount to target charge amount according to the target charge amount, the current battery charge amount, and a MAP table, the MAP table comprising a plurality of preset and continuous charge amount intervals, each charge amount interval comprising two charge amount nodes, and the charge interval comprising: early charging period, middle charging period, late charging period and final charging period;
   S104. according to the current battery charge amount, the target charge amount, and each charge amount node in the MAP table, respectively estimating the early charging period time from the current battery charge amount to the end value of the early charging period, the middle charging period time from the end value of the early charging period to the end value of the middle charging period, and the late charging period time from the end value of the middle charging period to the end value of the late charging period;
   S106. estimating the final charging period time according to multiple stored historical final charging period times;
   S108. accumulating the early charging period time, the middle charging period time, the late charging period time and the final charging period time to obtain a theoretical remaining charging time, and using the theoretical remaining charging time as the displayed remaining charging time and countdown displaying the displayed remaining charging time;
   S110. during the charging process, repeatedly executing S102-S108 at preset time intervals, and correcting the displayed remaining charging time displayed in the current cycle according to the theoretical remaining charging time determined in the current cycle until the current battery charge amount reaches the begin value of the final charging period;
   S112. when the current battery charge amount reaches the begin value of the final charging period, using the final charging period time as the displayed remaining charging time and countdown displaying the displayed remaining charging time until the battery charge reaches the target charge amount.

2. The remaining battery charging time estimation method according to claim 1, **characterized in that** estimating the final charging period time according to the multiple stored historical final charging period times comprises:
   using the average value of the multiple stored historical final charging period times as the final charging period time, wherein the historical final charging period time is the actual charging time from the begin value of the final charging period time to the target charge amount in the historical final charging period time.

3. The remaining battery charging time estimation method according to claim **1, characterized in that**, the begin value of the final charging period time is determined by the service life of the battery combined with the initial test data of the battery and the usage data of the battery using a specific SOC setting method or a specific potential setting method.

4. The remaining battery charging time estimation method according to claim **1, characterized in that**, determining a plurality of charging intervals from current battery charge amount to target charge amount according to the target charge amount, the current battery charge amount, and the MAP table, comprises:
   when the difference between the current battery charge amount and the end value of the late charging period is a plurality of the charge amount intervals, using the interval in which a termination node is located as the early charging period, wherein the termination node is a charge amount node which has the lowest difference with the current battery charge in the MAP table, and using the termination node to the starting node in the MAP table interval where the end value of the late charging period is located as the middle charging period, acting the starting node in the MAP table interval where the end value of the late charging period is located to the end value of the late charging period as the late charging period, and acting the end value of the late charging period to the target charge amount as the final charging period.

**5.** The remaining battery charging time estimation method according to claim **4, characterized in that**, according to the current battery charge amount, the target charge amount, and each charge amount node in the MAP table, respectively estimating the early charging period time from the current battery charge amount to the end value of the early charging period, the middle charging period time from the end value of the early charging period to the end value of the middle charging period, and the late charging period time from the end value of the middle charging period to the end value of the late charging period, comprises:

obtaining the charging current in the MAP table corresponding to each charging stage, and calculating the average charging current in the current charging stage according to the charging current collected in the current charging stage of the battery;

calculating the remaining charging time of the battery in the current charging stage according to the terminal value of the battery in the current charging stage, the current charge amount of the battery, and the average charging current in the current charging stage;

based on the terminal value of each charging stage after the current charging stage and the charging current in each subsequent charging stage, calculating the remaining charging time of the battery in each charging stage after the current charging stage and before the final charging period.

**6.** The remaining battery charging time estimation method according to claim **1, characterized in that**, correcting the displayed remaining charging time displayed in the current cycle according to the theoretical remaining charging time determined in the current cycle by the following formula:

$$T_{dispk+1} = T_{dispk} - \eta * (T_{dispk} / T_{theok}) * T_{step}$$

Among them, $T_{dispk+1}$ is the displayed remaining charging time of the k+1th sampling time, $T_{dispk}$ is the displayed remaining charging time of the kth sampling time, $\eta$ is the correction factor, and $T_{theok}$ is the theoretical remaining charging determined at the kth sampling time Time, $T_{step}$ preset time period.

**7.** A remaining battery charging time estimation apparatus, **characterized in that**, the apparatus comprises:

a charging interval determination module, configured to perform determining a plurality of charging intervals from current battery charge amount to target charge amount according to the target charge amount, the current battery charge amount, and a MAP table, the MAP table comprising a plurality of preset and continuous charge amount intervals, each charge amount interval comprising two charge amount nodes, and the charge interval comprising: early charging period, middle charging period, late charging period and final charging period;

a non-final charging period time determination module, configured to perform according to the current battery charge amount, the target charge amount, and each charge amount node in the MAP table, respectively estimating the early charging period time from the current battery charge amount to the end value of the early charging period, the middle charging period time from the end value of the early charging period to the end value of the middle charging period, and the late charging period time from the end value of the middle charging period to the end value of the late charging period;

a final charging period time determination module, configured to estimate the final charging period time based on a plurality of stored historical final charging period times;

a first theoretical charging time determination module, configured to perform accumulating the early charging period time, the middle charging period time, the late charging period time and the final charging period time to obtain a theoretical remaining charging time, and using the theoretical remaining charging time as the displayed remaining charging time and countdown display the displayed remaining charging time;

a repeated execution module, configured to perform during the charging process, returning to the charging interval determination module, the non-final charging period time determination module, the final charging period time determination module, and the first theoretical charging time determination module at preset time intervals during the charging process, and correcting the displayed remaining charging time displayed in the current cycle according to the theoretical remaining charging time determined in the current cycle until the current battery charge amount reaches the begin value of the final charging period;

a second theoretical charging time determination module, configured to perform when the current battery charge amount reaches the begin value of the final charging period, using the final charging period time as the displayed remaining charging time and countdown displaying the displayed remaining charging time until the battery charge reaches the target charge amount.

8.  The remaining battery charging time estimation apparatus according to claim **7, characterized in that**, the final charging period time determination module comprises: a final charging period time determining unit, configured to perform the calculation of the average value of a plurality of stored historical final charging period times as the final charging period time, wherein the historical final charging period time is the actual charging time from the begin value of the final charging period time to the target charge amount in the historical final charging period time.

9.  A computer-readable storage medium, at least one instruction or at least one section of program is stored in the computer-readable storage medium, and the at least one instruction or at least one section of program is loaded and executed by a processor to realize the remaining battery charging time estimation method according to any one of claims **1-6.**

10. An electronic apparatus, comprising at least one processor, and a memory communicatively connected to the at least one processor; wherein, the memory stores instructions that can be executed by at least one processor, and the at least one processor implements the remaining battery charging time estimation method as described in any of claims **1-6** by executing the instructions stored in the memory.

determining a plurality of charging intervals from current battery charge amount to target charge amount according to the target charge amount, the current battery charge amount, and a MAP table, the MAP table including a plurality of preset and continuous charge amount intervals, each charge amount interval including two charge amount nodes, and the charge interval including: early charging period, middle charging period, late charging period and final charging period

102

according to the current battery charge amount, the target charge amount, and each charge amount node in the MAP table, respectively estimating the early charging period time from the current battery charge amount to the end value of the early charging period, the middle charging period time from the end value of the early charging period to the end value of the middle charging period, and the late charging period time from the end value of the middle charging period to the end value of the late charging period

104

estimating the final charging period time according to multiple stored historical final charging period times

106

accumulating the early charging period time, the middle charging period time, the late charging period time and the final charging period time to obtain a theoretical remaining charging time, and using the theoretical remaining charging time as the displayed remaining charging time and countdown displaying the displayed remaining charging time

108

during the charging process, repeatedly executing S102-S108 at preset time intervals, and correcting the displayed remaining charging time displayed in the current cycle according to the theoretical remaining charging time determined in the current cycle until the current battery charge amount reaches the begin value of the final charging period

110

when the current battery charge amount reaches the begin value of the final charging period, using the final charging period time as the displayed remaining charging time and countdown displaying the displayed remaining charging time until the battery charge reaches the target charge amount

112

FIG.1

| T \ SOC | [0% , 5%) | [5% , 10%) | ...... | [95% , 97%) | [97% , 100%) | 100% |
|---|---|---|---|---|---|---|
| ... | | | | | | |
| 10℃ | ① | ② | ② | ② | ③ | ④ |
| ... | | | | | | |
| 40℃ | | | | | | |

① early charging period
② middle charging period
③ late charging period
④ final charging period

non-final charging period

PackSoc current SOC of battery

begin point of final charging period

TrtSoc charge target SOC

initial battery capacity

target charge amount

FIG.2

emaining battery charging time estimation apparatus — 710

charging interval determination module

non-final charging period time determination module — 720

final charging period time determination module — 730

first theoretical charging time determination module — 740

repeated execution module — 750

second theoretical charging time determination module — 760

FIG.3

| INTERNATIONAL SEARCH REPORT | International application No. |
| --- | --- |
| | **PCT/CN2022/099327** |

| A. | CLASSIFICATION OF SUBJECT MATTER |
| --- | --- |

G01R 31/388(2019.01)i; G01R 31/36(2019.01)i; G01R 31/382(2019.01)i; G01R 31/367(2019.01)i; G06F 30/20(2020.01)i; H01M 10/44(2006.01)i; B60L 58/10(2019.01)i; H02J 7/00(2006.01)i

According to International Patent Classification (IPC) or to both national classification and IPC

| B. | FIELDS SEARCHED |
| --- | --- |

Minimum documentation searched (classification system followed by classification symbols)

G01R31;H01M10;G06F30;H02J7;B60L58

Documentation searched other than minimum documentation to the extent that such documents are included in the fields searched

Electronic data base consulted during the international search (name of data base and, where practicable, search terms used)

CNTXT; ENTXTC; ENTXT; VEN; CNKI: 充电, 剩余, 剩下, 时间, MAP表, 充电区间, 充电阶段, 充电末期, 后期, 末端, 末段, 尾端, 尾段, 最后, 恒压, 恒流, charg+, residual+, remain+, time, duration, interval, "MAP", stage, finally, last+, end+, constant, voltage, current

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| PX | CN 113484779 A (ZHEJIANG GEELY AUTOMOBILE HOLDINGS LIMITED et al.) 08 October 2021 (2021-10-08)<br>claims 1-10, and description, paragraphs 6-155 | 1-10 |
| PX | CN 113504479 A (ZHEJIANG GEELY AUTOMOBILE HOLDINGS LTD. et al.) 15 October 2021 (2021-10-15)<br>description, paragraphs 79-109, and figure 4 | 1-10 |
| Y | CN 110909443 A (BEIHANG UNIVERSITY) 24 March 2020 (2020-03-24)<br>description, paragraphs 4-85 | 1-3, 7-10 |
| Y | CN 112216886 A (SVOLT ENERGY TECHNOLOGY CO., LTD.) 12 January 2021 (2021-01-12)<br>description, paragraphs 4-71 | 1-3, 7-10 |
| A | CN 110518302 A (SVOLT ENERGY TECHNOLOGY CO., LTD.) 29 November 2019 (2019-11-29)<br>entire document | 1-10 |

☑ Further documents are listed in the continuation of Box C.  ☑ See patent family annex.

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| **03 August 2022** | **23 August 2022** |

| Name and mailing address of the ISA/CN | Authorized officer |
| --- | --- |
| **China National Intellectual Property Administration (ISA/ CN)**<br>**No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

**INTERNATIONAL SEARCH REPORT**

| International application No. |
|---|
| **PCT/CN2022/099327** |

**C. DOCUMENTS CONSIDERED TO BE RELEVANT**

| Category* | Citation of document, with indication, where appropriate, of the relevant passages | Relevant to claim No. |
|---|---|---|
| A | CN 108646190 A (NINGDE CONTEMPORARY AMPEREX TECHNOLOGY CO., LTD.) 12 October 2018 (2018-10-12) entire document | 1-10 |
| A | CN 103902004 A (KENIU NETWORK TECHNOLOGY (BEIJING) CO., LTD.) 02 July 2014 (2014-07-02) entire document | 1-10 |
| A | JP 2014230447 A (HONDA MOTOR CO., LTD.) 08 December 2014 (2014-12-08) entire document | 1-10 |
| A | CN 112198441 A (SVOLT ENERGY TECHNOLOGY CO., LTD.) 08 January 2021 (2021-01-08) entire document | 1-10 |
| A | CN 109660005 A (SHENZHEN GOLDWAN ELECTRONIC LTD.) 19 April 2019 (2019-04-19) entire document | 1-10 |
| A | US 2012293122 A1 (MURAWAKA, K. et al.) 22 November 2012 (2012-11-22) entire document | 1-10 |

Form PCT/ISA/210 (second sheet) (January 2015)

<table>
<tr><td colspan="2">INTERNATIONAL SEARCH REPORT<br>Information on patent family members</td><td colspan="2">International application No.<br><br>PCT/CN2022/099327</td></tr>
</table>

| Patent document cited in search report | | | Publication date (day/month/year) | Patent family member(s) | | | Publication date (day/month/year) |
|---|---|---|---|---|---|---|---|
| CN | 113484779 | A | 08 October 2021 | None | | | |
| CN | 113504479 | A | 15 October 2021 | None | | | |
| CN | 110909443 | A | 24 March 2020 | None | | | |
| CN | 112216886 | A | 12 January 2021 | None | | | |
| CN | 110518302 | A | 29 November 2019 | CN | 110518302 | B | 23 February 2021 |
| CN | 108646190 | A | 12 October 2018 | CN | 108646190 | B | 12 January 2021 |
| CN | 103902004 | A | 02 July 2014 | WO | 2015143992 | A1 | 01 October 2015 |
| | | | | CN | 103902004 | B | 08 February 2017 |
| JP | 2014230447 | A | 08 December 2014 | JP | 5898643 | B2 | 06 April 2016 |
| CN | 112198441 | A | 08 January 2021 | None | | | |
| CN | 109660005 | A | 19 April 2019 | None | | | |
| US | 2012293122 | A1 | 22 November 2012 | JP | 2011130580 | A | 30 June 2011 |
| | | | | EP | 2512861 | A2 | 24 October 2012 |
| | | | | WO | 2011073765 | A2 | 23 June 2011 |
| | | | | CN | 102666186 | A | 12 September 2012 |
| | | | | US | 9000730 | B2 | 07 April 2015 |
| | | | | WO | 2011073765 | A3 | 05 April 2012 |
| | | | | EP | 2512861 | B1 | 03 December 2014 |
| | | | | JP | 5051794 | B2 | 17 October 2012 |
| | | | | CN | 102666186 | B | 26 November 2014 |

Form PCT/ISA/210 (patent family annex) (January 2015)